# EUROPÄISCHE PATENTSCHRIFT

(11) **EP 1 476 891 B1**
(45) Veröffentlichungstag und Bekanntmachung des Hinweises auf die Patenterteilung: **19.10.2011**
(21) Anmeldenummer: 03714746.9
(22) Anmeldetag: 18.02.2003
(51) Int. Cl.: H01J 37/34, C23C 14/35

(54) **VORRICHTUNG UND VERFAHREN ZUM BESCHICHTEN EINES SUBSTRATES MIT MAGNETISCHEN ODER MAGNETISIERBAREN WERKSTOFFEN**
DEVICE AND METHOD OF COATING A SUBSTRATE WITH MAGNETIC OR MAGNETISABLE MATERIAL
DISPOSITIF ET PROCEDE DE REVETEMENT D'UN SUBSTRAT DE MATERIAU MAGNETIQUE OU MAGNETISABLE

(30) Priorität: 19.02.2002 EP 02003752
(43) Veröffentlichungstag der Anmeldung: 17.11.2004
(73) Patentinhaber: Singulus Technologies AG, 63796 Kahl/Main (DE)
(72) Erfinder: MAASS, Wolfram, 63589 Linsengericht/Grossenhausen (DE); SCHNEIDER, Roland, 63679 Schotten-Michelbach (DE); MÜHLFELD, Uwe, 63939 Wörth (DE); MUNDORF, Christoph, 63796 Kahl (DE); OCKER, Berthold, 63454 Hanau (DE); LANGER, Jürgen, 63071 Offenbach (DE); SCHNEIDER, Dietmar, 61137 Schöneck (DE); JOHN, Helmut, 63452 Hanau (DE); SPIELVOGEL, Rudi, 63607 Wächtersbach (DE); CLAUSSEN, Eric, 63457 Hanau (DE); STERN, Wolfgang, 63456 Hanau (DE); LAUSMANN, Helmut, 63584 Gründau (DE); LANDMANN, Matthias, 61130 Nidderau (DE); SOMMERFELD, Reinhard, 63486 Bruchköbel-Rossdorf (DE)
(74) Vertreter: Vossius & Partner
(86) Internationale Anmeldenummer: PCT/EP2003/001628
(87) Internationale Veröffentlichungsnummer: WO 2003/071579

(56) Entgegenhaltungen:
- EP-A- 1 067 577
- WO-A-97/03220
- DE-A- 4 135 939
- DE-A- 19 643 841
- US-A- 4 601 806
- US-A- 5 630 916
- US-B1- 6 217 272
- PATENT ABSTRACTS OF JAPAN vol. 017, no. 589 (C-1124), 27. Oktober 1993 (1993-10-27) & JP 05 171432 A (FUJITSU LTD), 9. Juli 1993 (1993-07-09)
- PATENT ABSTRACTS OF JAPAN vol. 013, no. 174 (C-589), 25. April 1989 (1989-04-25) & JP 01 004472 A (TOSHIBA CORP), 9. Januar 1989 (1989-01-09)

## Beschreibung

Die Erfindung betrifft eine Vorrichtung und ein Verfahren zum Beschichten eines Substrates, durch Kathodenzerstäubung mit magnetischen bzw. magnetisierbaren Werkstoffen.

Aus der- DE-A-196 43 841 ist eine Vorrichtung zum Beschichten von Substraten mit magnetisierbaren Werkstoffen bekannt. Diese Vorrichtung besteht aus einem kreisscheibenförmigen, rotierbar gelagerten Substrathalter zur Aufnahme mindestens eines Substrates, der auf seiner dem Substrat abgewandten Seite und längs des Umfanges mit einer konzentrischen Dunketraumabschirmung versehen ist, aus einer Einrichtung zur Erzeugung eines zur Substratebene parallelen äußeren Feldes sowie mindestens einer Kathode, unter der sich der Substrathalter während der Beschichtung dreht. Das äußere Feld dieser Vorrichtung wird durch einen Elektromagneten mit Joch erzeugt, wobei das untere Jochteil mit der Erregerspule in der Dunkelraumabschirmung und seine verlängerten Polschuhe elektrisch getrennt im Substratträger in der Nähe des Substrates untergebracht sind. Eingelassen in den Substrathalter wird das Substrat zusammen mit der Einrichtung zur Erzeugung des äußeren Feldes im dynamischen Betrieb dieser Vorrichtung unter der Kathode durchgedreht und mit dem Targetmaterial beschichtet, d.h. während der Beschichtung wird das Substrat relativ zum Target senkrecht zur Richtung der Feldlinien des Magnetfeldes bewegt.

Aus der DE-A-41 35 939 ist eine rotationssymmetrische Zerstäubungskathode bekannt, die auch in Form einer Langkathode ausgebildet sein wobei hinter der Kathode eine Magnetanordnung zum Erzeugen eines Magnetronfeldes angeordnet ist. Bei Ausbildung dieser Zerstäubungskathode ats Langkathode wird das Substrat dann bei seiner Relatiwerschiebung gegenüber der Kathode beschichtet.

Zum Stand der Technik wird ferner verwiesen auf WO 97/03220 A, EP 1 067 577 A, US 4 601 806 A, US 5 630 916 A, US 6:217 272 B1, JP-05-171432 A und JP-01-004472 A.

US 6 217 272B1 offenbart eine Vorrichtung zum Beschichten eines Substrates mit mehreren Schichten mittels einer zylindrischen Zerstäubungskathodenanordnung.

In der Speichertechnologie findet zunehmend der sogenannte MRAM (Magnetic Random Access Memory) als nicht flüchtiger Speicher Verwendung. Bei diesen Speichern wird die zu speichernde Information in der Magnetisierungsrichtung eines Partikels einer magnetischen Beschichtung gespeichert. Das Auslesen der Information kann mittels zweier alternativer Verfahren erfolgen, des sogenannten TMR-Effektes (Tunnel Magneto Resistance) oder des sogenannten GMR-Effektes (Giant Magneto Resistance). Für diese Art der Speicher ist es erforderlich, extrem dünne Schichten (in der Größenordnung von wenigen Å), die extrem gleichmäßig auf einem Substrat aufgetragen werden, bereitzustellen. Die Speicherfähigkeit dieser extrem dünnen Schicht wird durch eine Magnetisierung der Schicht auf dem Substrat erreicht. Dabei wird die leichte Magnetisierungsachse des magnetischen Materials, beispielsweise eines ferromagnetischen Materials, über die gesamte Fläche des Substrates in eine Richtung ausgerichtet. Bei dieser Ausrichtung der leichten Magnetisierungsachse sind höchstens Abweichungen in der Größenordnung von +/- 2° zulässig.

Ferner ist es für solche magnetische Speicher notwendig, bis zu zehn oder mehr Schichten übereinander aufzubringen.

Mit bisher bekannten Zerstäubungskathoden ist es nicht möglich, solch extrem dünne Schichten mit der erforderlichen Genauigkeit bezüglich der Ausrichtung der leichten Magnetisierungsrichtung herzustellen. Die Verwendung von rotationssymmetrischen Zerstäubungskathoden ist beispielsweise mit dem Nachteil verbunden, daß das in der Zerstäubungskathode für die Zerstäubung notwendige rotationssymmetrische Magnetfeld eine Ausrichtung der leichten Magnetisierungsachse in den Substratschichten in eine Richtung stört.

Ein weiterer Nachteil von rotationssymmetrischen Magnetron-Zerstäubungskathoden liegt darin, daß mit diesen bei den erforderlichen Schichtdicken von wenigen Å die erforderliche extreme Homogenität und Gleichmäßigkeit nicht zu erreichen ist.

Ein weiteres Problem in der Erzeugung von magnetisierbaren Schichten, insbesondere für MRAM-Speicher, auf einem Substrat liegt in dem extrem hohen Vakuum, das erforderlich ist, um die extrem dünnen Schichten mit der extremen Gleichmäßigkeit auf das Substrat aufbringen zu können.

Der Erfindung liegt die Aufgabe zugrunde, eine Zerstäubungskathode anzugeben, mit der eine Ausrichtung der leichten Magnetisierungsachse eines magnetisierbaren Werkstoffes während des Aufbringens des Werkstoffes auf ein Substrat möglich ist.

Ferner ist eine Vorrichtung und ein Verfahren zum Beschichten eines Substrates mit mehreren Schichten aus gleichem oder unterschiedlichem Material durch Kathodenzerstäubung anzugeben, mit der die für magnetische Speicher erforderlichen mehreren dünnen Schichten aus verschiedenen Materialien mit der geforderten hohen Gleichmäßigkeit bereitgestellt werden können.

Diese Aufgabe wird erfindungsgemäß mit den Merkmalen der Patentansprüche gelöst.

Zum Aufbringen von magnetischen Werkstoffen auf Substrate mit der notwendigen Ausrichtung der leichten Magnetisierungsachse des Werkstoffes geht die Erfindung von dem Grundgedanken aus, eine Zerstäubungskathode mit einer Einrichtung zum Erzeugen eines externen Magnetfeldes zu versehen, wobei das Magnetfeld im wesentlichen parallel verlaufende Magnetfeldlinien aufweist die im wesentlichen in der Ebene des zu beschichtenden Substrates liegen. Ferner ist eine Einrichtung zum Bewegen des Substrates während der Kathodenzerstäubung relativ zum Target in der Substratebene in Richtung der Magnetfeldlinien des externen Magnetfeldes vorgesehen. Vorzugsweise ist die Stärke des externen Magnetfeldes abhängig von dem verwendeten magnetischen Werkstoff einstellbar, so daß bei der Ausrichtung der leichten Magnetisierungsachse in der magnetischen Schicht geeignet auf den verwendeten Werkstoff Rücksicht genommen werden kann.

Weiter bevorzugt ist die erfindungsgemäße Zerstäubungskathode eine Langkathode. Die Verwendung einer Langkathode ist mit dem Vorteil verbunden, daß die von der Magnetanordnung hervorgerufenen Streufelder nicht rotationssymmetrisch verlaufen, sondern sich mit den im wesentlichen parallel verlaufenden Magnetfeldlinien des externen Magnetfeldes decken, so daß diese Streufelder bei der Ausrichtung der magnetischen Partikel nur noch eine untergeordnete Rolle spielen. Ferner ist die Verwendung einer Langkathode mit dem Vorteil verbunden, daß das ,zu beschichtende Substrat auf einfache Art und Weise in seiner Ebene und senkrecht zur Längsrichtung der Langkathode unter dem Target hindurch bewegt werden kann. Dieser Unterschied zum Stand der Technik (wo das Magnetfeld mit dem Substrat mitbewegt wird), d.h. das ortsfeste externe Magnetfeld bei der vorliegenden Erfindung, ist mit dem besonderen Vorteil verbunden, daß bei einer Relativbewegung des Substrates unter dem Target hindurch und durch das externe Magnetfeld zum einen eine einfache und exakte Ausrichtung der leichten Magnetisierungsachse ermöglicht wird, und andererseits unabhängig von der Leistung der Zerstäubungskathode auf einfache Art und Weise die gewünschte geringe Schichtdicke des aufzubringenden Werkstoffes eingestellt werden kann. Die Geschwindigkeit des Substrates bestimmt bei dieser Art der Beschichtung die Schichtdicke der aufzubringenden Schicht.

In der bevorzugten Ausführungsform, bei der die Zerstäubungskathode eine Langkathode ist, erstreckt sich die externe Magnetfelderzeugungseinrichtung entlang der Ausbreitungsrichtung bzw. Längsrichtung des Targets der Langkathode. Dies bedeutet, daß über die gesamte Länge des Targets ein externes Magnetfeld im wesentlichen senkrecht zur Längsrichtung des Target und im wesentlichen in der Substratebene ausgerichtet werden kann, um die leichte Magnetisierungsachse eines auf ein relativ zum Target bewegtes Substrat aufgebrachten Werkstoffes in Richtung des externen Magnetfelds auszurichten.

Da das Substrat notwendigerweise während der Beschichtung unter Einhaltung eines gewissen Abstandes zum Target angeordnet ist, ist vorzugsweise ferner eine Abschirmung zum Abschirmen des nicht zu beschichtenden Bereiches der Kathode zwischen Target und Substrat vorgesehen.

Weiter bevorzugt ist bei der erfindungsgemäßen Zerstäubungskathode der Kathodengrundkörper mit dem darauf angeordneten Target in einem Prozeßraum angeordnet, während die dem Kathodengrundkörper und dem Target zugeordnete Magnetanordnung nicht in dem Prozeßraum vorgesehen ist, sondern von diesem durch eine Wand getrennt in der Umgebungsatmosphäre angeordnet ist. Diese Anordnung ist besonders vorteilhaft, um das beim Beschichten von Substraten für die Bereitstellung von magnetischen Speichern notwendige Ultrahochvakuum bereitzustellen. Durch diese bevorzugte Ausgestaltung bzw. Trennung zwischen Target und Magnetanordnung ist es möglich, die Öffnungen zum Prozeßraum wesentlich kleiner zu gestalten, da nur noch die Kühlflüssigkeitszuführung und Stromzuführung für die Kathode in den Prozeßraum erfolgen muß. Diese können jedoch kombiniert werden, so daß nur noch diese kombinierte Zuführung bei der bevorzugten Ausgestaltung abgedichtet werden muß. Somit sind wesentlich kleinere Dichtlängen möglich (diese betrugen bisher pro Target etwa einen Meter).

Die erfindungsgemäße Vorrichtung zum Beschichten eines Substrates mit mehreren Schichten durch Kathodenzerstäubung mit magnetischen oder magnetisierbaren Werkstoffen, zeichnet sich durch die in Anspruch 7 definierten Merkmale aus.

Durch diese erfindungsgemäße Anordnung der mehreren Zerstäubungskathoden, die für die Aufbringung mehrerer unterschiedlicher Schichten auf das Substrat erforderlich sind, in Form eines Kreises bzw. in Form einer Trommel ist es möglich, bei der Beschichtung der mehreren Schichten eine sehr hohe Gleichmäßigkeit und Homogenität zu erreichen, da das Substrat während der unterschiedlichen Beschichtungsvorgänge in seiner Ebene gehalten werden kann, während die verschiedenen Targets in die jeweilige Zerstäubungsposition gedreht werden können. Die Anordnung der Zerstäubungskathoden in Form einer Targettrommel ist ferner mit dem Vorteil verbunden, daß die gesamte Beschichtungsvorrichtung sehr kompakt ist. Eine solche Targettrommel kann beispielsweise liegend, d.h. mit horizontaler Längsachse ohne weiteres an herkömmliche Substrat-Beschickungsmodule angebaut werden.

Vorzugsweise sind die Zerstäubungskathoden Langkathoden. Für die damit verbunden Vorteile gilt das oben genannte entsprechend.

Weiter ist die erfindungsgemäße Beschichtungsvorrichtung mit einer externen Magnetfelderzeugungseinrichtung versehen, deren Magnetfeldlinien im wesentlichen parallel und in der Ebene des Substrates verlaufen. Hierdurch werden die magnetischen Partikel bezüglich ihrer leichten Magnetisierungsachse ausgerichtet, und für die damit verbundenen Vorteile gilt das oben gesagte entsprechend.

Die externe Magnetfelderzeugungseinrichtung ist bezüglich der Zerstäubungskathodenanordnung ortsfest, d.h. die Zerstäubungskathodenanordnung ist relativ zur Magnetfelderzeugungseinrichtung drehbar. Je nach zu verwendendem Target wird dieses in der Beschichtungsvorrichtung durch Drehen der Zerstäubungskathodenanordnung in die Zerstäubungsposition relativ zum Substrat gedreht und befindet sich somit auch im Einflußbereich des externen Magnetfeldes, das auf die Schicht einwirkt, die vom gerade verwendeten Target auf das Substrat aufgebracht wird.

Vorzugsweise ist bei der erfindungsgemäßen Beschichtungsvorrichtung nicht für jede Zerstäubungskathode bzw. nicht für jedes Target eine gesonderte Magnetanordnung zur Erzeugung des Magnetron-Magnetfeldes vorgesehen, sondern lediglich eine oder zwei Magnetanordnungen, die wahlweise über dem zu verwendenden Target in Position gebracht werden können. Dies ermöglicht eine weitere Kompaktierung der erfindungsgemäßen Beschichtungsvorrichtung, d.h. die Targettrommel kann einen kleineren Durchmesser aufweisen, da im Inneren nur noch Raum für eine oder gegebenenfalls zwei Magnetron-Magnetanordnungen vorhanden sein muß. So kann beispielsweise für magnetische und nicht-magnetische Targetmaterialien eine unterschiedliche Magnetanordnung bereitgestellt sein bzw. verwendet werden.

Das erfindungsgemäße Verfahren zum Beschichten eines Substrates durch Kathodenzerstäubung zeichnet sich durch die in Anspruch 15 definierten Merkmale und Verfahrensschritte aus.

Das erfindungsgemäße Verfahren zum Beschichten eines Substrates mit mehreren Schichten mit magnetischen oder magnetisierbaren Werkstoffen ist definiert in Anspruch 16.

Die Erfindung ist besonders geeignet für Viellagenschichten mit vielen verschiedenen Materialien auch außerhalb des Anwendungsbereiches der MRAM-Technologie.

Die Erfindung wird nachstehend unter Bezugnahme auf die beigefügten Zeichnung näher erläutert. Es zeigen:
- Figur 1: eine schematische Schnittdarstellung einer erfindungsgemäßen Beschichtungsvorrichtung mit einer Zerstäubungskathode in Form einer Langkathode;
- Figur 2: eine schematische Darstellung der Ausrichtung der leichten Magnetisierungsachse eines ferromagnetischen Materials auf einem Substrat;
- Figur 3: eine Schnittansicht einer erfindungsgemäßen Substrat- Beschichtungsvorrichtung mit Langkathoden;
- Figur 4: eine Schnittansicht der erfindungsgemäß bevorzugten Trennung von Magnetanordnung und Target;
- Figur 5: eine schematische Übersicht einer kompletten Beschichtungsanlage mit zwei erfindungsgemäßen Beschichtungsvorrichtungen; und
- Figur 6: eine schematische Schrägdarstellung der Bewegungseinrichtung für die translatorische Bewegung des Substrates.

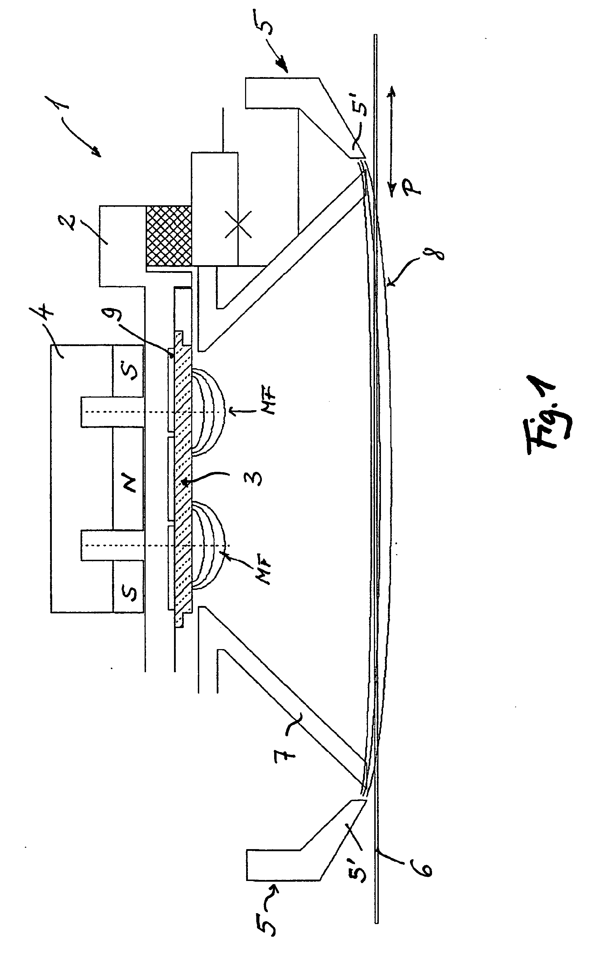

Figur 1 zeigt im Querschnitt anhand einer Langkathode, deren Längsachse senkrecht auf der Zeichenebene steht, den prinzipiellen Aufbau einer erfindungsgemäßen Beschichtungsvorrichtung mit Zerstäubungskathode 1. Die Zerstäubungskathode 1 dieser bevorzugten Ausführungsform weist einen Kathodengrundkörper 2 mit einem darauf. angeordneten Target 3 auf. Zwischen Target 3 und Kathodengrundkörper 2 sind Kühlkanäle 9 für ein Kühlfluid vorgesehen. Auf der dem Target abgewandten Seite des Kathodengrundkörpers ist eine Magnetanordnung 4 vorgesehen, deren magnetisches Feld MF, d.h. das Magnetronfeld, unterhalb des Targets angedeutet ist. Das Substrat 6 ist beabstandet von dem Target 3 angeordnet. In der gezeigten Ausführungsform befindet sich das Substrat 6 in einer Ebene, die im wesentlichen parallel zum Target 3 ist. Alternativ dazu kann die Ebene des Substrates auch leicht zur Ebene des Targets 3 geneigt sein.

Ferner ist eine Einrichtung 5 zum Erzeugen eines externen Magnetfeldes im Bereich des Substrats vorgesehen. In Figur 1 sind lediglich die beiden Polschuhe 5' dieser Einrichtung angedeutet; diese Polschuhe 5' stehen mit einer entsprechenden nicht dargestellten Spulenanordnung in elektromagnetischer Verbindung. Diese Magnetfelderzeugungseinrichtung 5 erzeugt ein externes Magnetfeld, dessen Feldlinien zwischen den Polschuhen 5' mit dem Bezugszeichen 8 in Figur 1 angedeutet sind. Die Magnetfeldlinien 8 dieses externen Magnetfeldes oder Richtmagnetfetdes verlaufen im wesentlichen in der Ebene des Substrates 6 und darin im wesentlichen parallel zueinander, um so die gewünschte parallele Ausrichtung der leichten Magnetisierungsachse MA im Substrat 6 zu erreichen.

Zwischen dem Target 3 und dem Substrat 6 ist ferner ein Abschirmung 7 vorgesehen, die nicht zu beschichtende Bestandteile der Beschichtungsvorrichtung gegenüber dem abgesputterten Targetmaterial abschirmt und lediglich eine Restfläche des Prozeßraums zwischen Target und Substrat bildet.

Die gewünschte Ausrichtung der leichten Magnetisierungsachse MA wird mit der erfindungsgemäßen Beschichtungvorrichtung erreicht, wenn das Substrat 6 während des Beschichtungsvorganges in seiner Ebene und in Richtung der Magnetfeldlinien 8 relativ zu dem Target bewegt wird.

Eine optimale Ausrichtung der leichten Magnetisierungsachse wird besonders bei Verwendung einer Langkathode erreicht, da dann die magnetischen Streufelder der Magnetron-Magnetanordnung 4 sich bereits mit dem Magnetfeld 8 der externen Magnetfelderzeugungseinrichtung 5 decken. Im Falle einer rotationssymmetrischen Zerstäubungskathode bzw. Magnetanordnung 4 wäre das magnetische Streufeld nicht mit dem Magnetfeld der externen Magnetfelderzeugungseinrichtung 5 deckungsgleich, was zu einer gegebenenfalls verschlechterten Ausrichtung der leichten Magnetisierungsachse führt. Gleichwohl sind auch solche und andere Nicht-Langkathodenanordnungen im Rahmen der Erfindung vorgesehen.

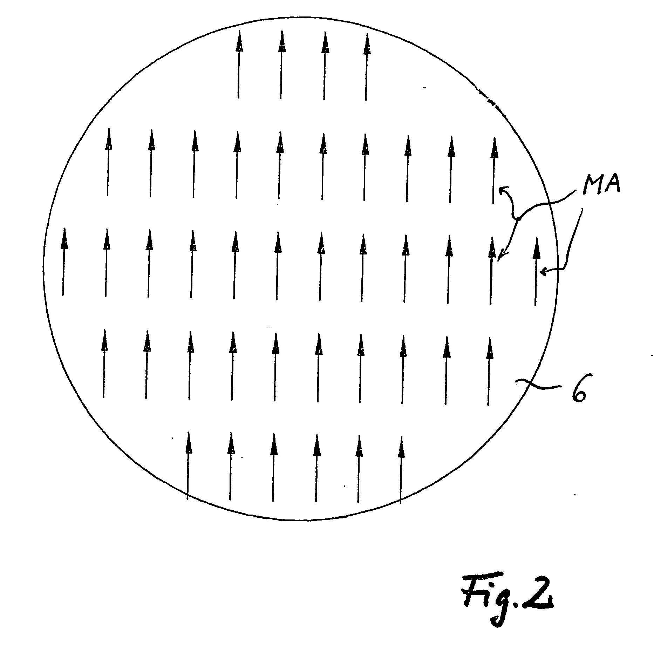

Die Ausrichtung der leichten Magnetisierungsachse MA ist schematisch in Figur 2 veranschaulicht. Die Ausrichtung der leichten Magnetisierungsachse wie in Figur 2 gezeigt, d.h. einheitlich in eine Richtung, ist besonders dann notwendig, wenn das zu beschichtende Substrat als Magnetspeicher, insbesondere als MRAM-SpeicherMaterial verwendet werden soll.

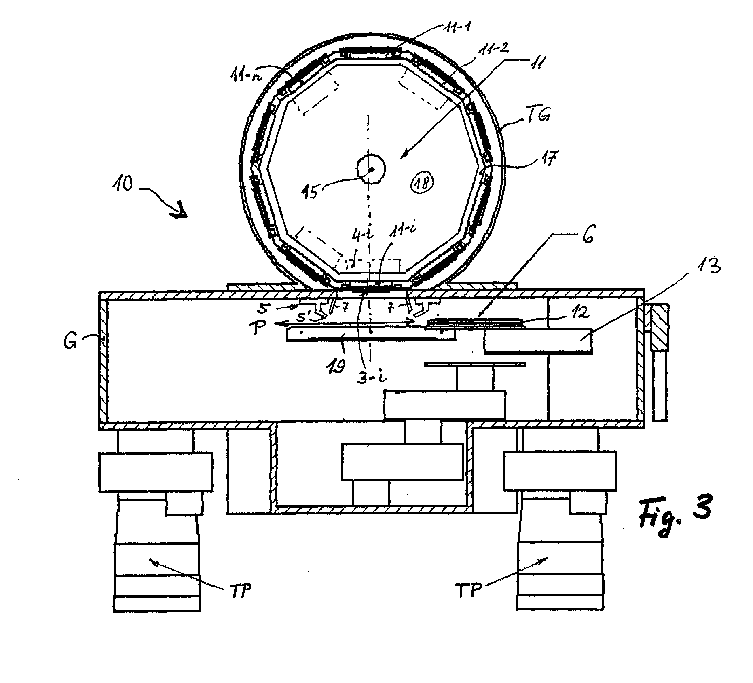

Figur 3 zeigt schematisch eine Schnittansicht der erfindungsgemäßen Vorrichtung 10 zum Beschichten eines Substrates 6 mit mehreren Schichten unterschiedlicher Materialien durch Kathodenzerstäubung. Im oberen Bereich des Bildes ist die Zerstäubungskathodenanordnung 11 mit den mehreren Zerstäubungskathoden 11-1, 11-2, ..., 11-n dargestellt. Die Zerstäubungskathoden befinden sich mit den radial nach außen weisenden Targetnutzflächen auf einer Kreisbahn, um dessen Mittelpunkt die Zerstäubungskathodenordnung 11 oder Targettrommel innerhalb eines Trommelgehäuses TG relativ zu dem Substrat drehbar ist. Das Substrat 6 ist innerhalb eines Gehäuses G auf einem Substrathalter 12 in Pfeilrichtung P relativ zu der Zerstäubungskathodenanordnung, d.h. der Targettrommel 11, horizontal und parallel zur Targetoberfläche des Targets 3-i bewegbar. Dabei ist die gerade für die Beschichtung zu verwendende Bestäubungskathode 11-i mit dem Target 3-i in der Targettrommel 11 an unterster Stelle, d.h. oberhalb der Beschichtungsposition des Substrates 6 angeordnet. Das Trommelgehäuse TG und das Gehäuse G bilden zusammen einen Vakuumraum, der über Pumpen (z.B. Turbomolekularpumpen TP) abgepumpt wird.

Gegebenenfalls werden durch eine einmalige oder mehrmalige Horizontalbewegung des Substrates 6 unterhalb des Targets 3-i je nach gewünschter Schichtdicke eine oder mehrere Schichten des vom Target 3-i zu zerstäubenden Materials auf das Substrat 6 aufgebracht.

Wenn die Zerstäubung mit dem Target 3-i abgeschlossen ist, wird die Targettrommel um ihre Achse 15 gedreht, bis die Zerstäubungskathode mit dem nächsten gewünschten Target mit anderem Targetmaterial sich in der Zerstäubungsposition, d.h. an unterster Stelle der Targettrommel 11 befindet. Dann erfolgt gegebenenfalls erneut ein einmaliges oder mehrmaliges Bewegen des Substrates 6 unterhalb des Targets zum Auftragen einer Schicht.

Ein Abschirmblech 19 sowie die Abschirmung 7 dienen zum Abschirmen der Umgebung gegen zerstäubtes, nicht genutztes Targetmaterial.

Um die Magnetisierung einer aufgetragenen Schicht auf dem Substrat vorzunehmen, ist erfindungsgemäß noch eine Magnetfelderzeugungseinrichtung 5, wie im Zusammenhang mit Figur 1 erläutert, vorgesehen.

Zum Bewegen des Substrathalters 12 mit dem Substrat 6 dient ein mehrteiliger Roboterarm 13, der eine extrem genaue lineare Bewegung des Substrates relativ zu der Targettrommel 11 ermöglicht. Eine nicht dargestellte Transporteinheit transportiert das Substrat 6 zum Substrathalter 12 am Roboterarm 13 und wieder weg.

Je nach Anwendungsbereich weist die Targettrommel 11 mehrere Zerstäubungskathoden mit Targets auf. Bevorzugt sind acht oder zehn Zerstäubungskathoden.

Die Targets 3-1 bis 3-n der verschiedenen Zerstäubungskathoden 11-1, 11-2, ... 11-n bestehen aus unterschiedlichen Materialien entsprechend der gewünschten Zusammensetzung der auf dem Substrat 6 aufzutragenden Schichten.

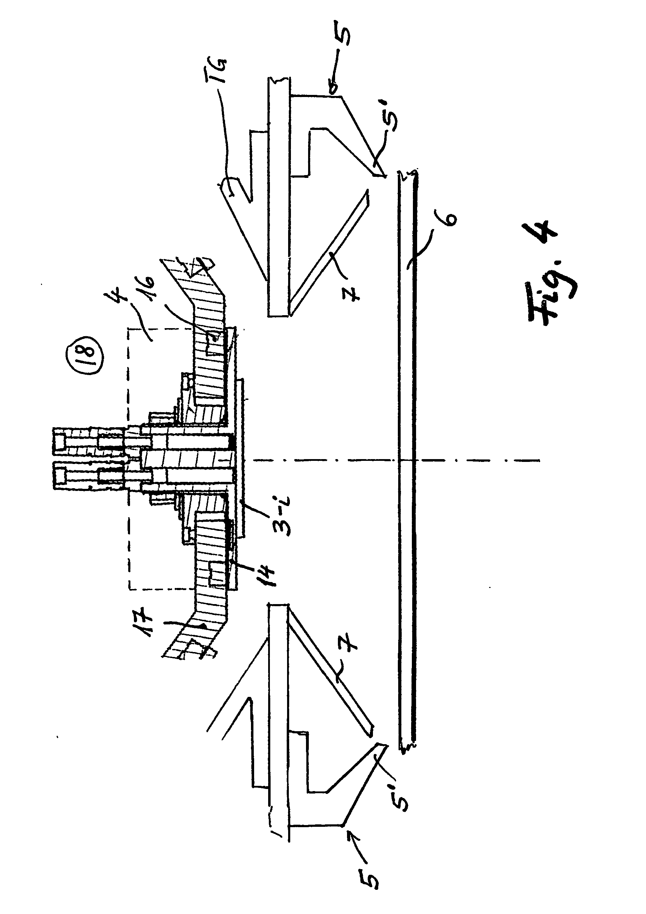

Figur 4 veranschaulicht die erfindungsgemäß bevorzugte Trennung von Target 3 und Magnetron-Magnetanordnung. Die Trommelwand. 17 .der Targettrommel weist lediglich eine kleine Durchführung für die Wasser- und Stromzufuhr auf. Das Target 3 ist auf einer Grundplatte, beispielsweise einer Kupferplatte 14 im Inneren des Prozeßraümes vorgesehen. Die Magnetron-Magnetanordnung 4 (in Figur 4 nur schematisch gezeigt) ist vom Prozeßraum getrennt außerhalb der Trommelwand 17 (d.h. radial innerhalb der ringförmigen Trommel 11) angeordnet. Vorzugsweise ist dabei der Abstand zwischen Target 3 und Magnetron-Magnetanordnung 4 so gering wie möglich.

Figur 4 zeigt auch Isolierleisten 16 zum elektrischen Isolieren der Kathode gegen die Trommelwand 17, die auch zum Abdichten zwischen dem unter Vakuum stehenden Prozeßraum und dem unter Normaldruck stehenden Trommelinnenraum 18 dienen:

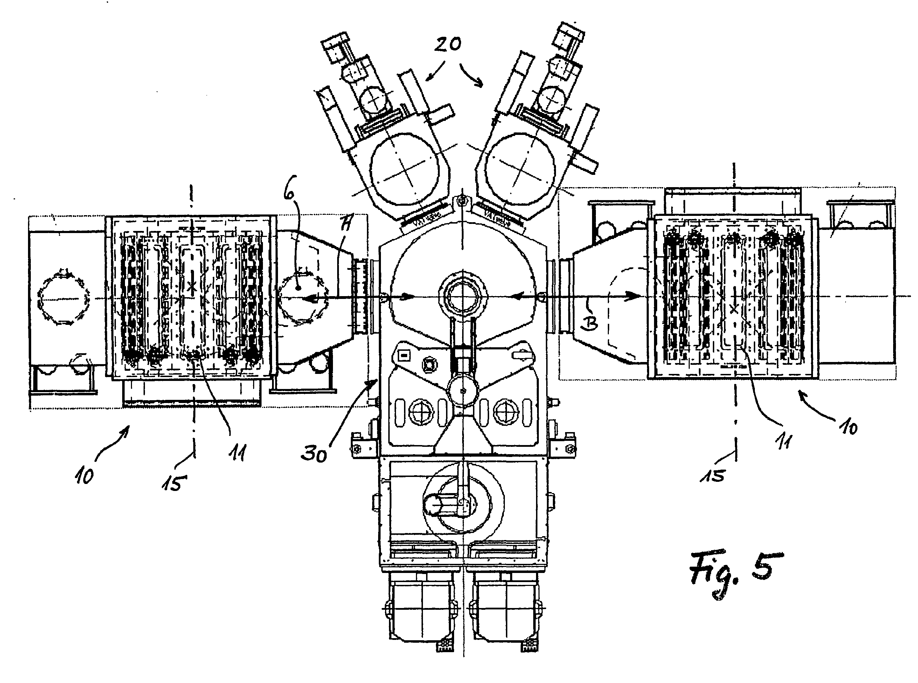

Figur 5 zeigt eine schematische Draufsicht einer kompletten Beschichtungsanlage mit zwei erfindungsgemäßen Beschichtungsvorrichtungen 10, die an einem Beschickungsmodul 30 angekoppelt sind. Die zu beschichtenden Substrate werden von dem Beschickungsmodul 30 in die Beschichtungsvorrichtungen 10 eingerührt, um dann anschließend in den Beschichtungsvorrichtungen mit den einzelnen Beschichtungen versehen zu werden. Wie in Figur 5 gezeigt, sind die Achsen 15 der Targettrommeln 11 senkrecht zur Bewegungsrichtung.(Pfeile A und B) der Substrate von dem Beschickungsmodul 30 in die Beschichtungsvorrichtung 10 angeordnet. Wie bereits erläutert, wird in der Beschichtungsvorrichtung 10 das Substrat 6 unterhalb des an unterster Stelle angeordneten Targets 3-i entlang bewegt. Anschließend wird die Targettrommel 11 je nach gewünschtem Schichtaufbau auf dem Substrat so um die Achse 15 gedrehet, daß das nächste gewünschte Target oberhalb der Bewegungsbahn des Substrates 6 zur Beschichtung desselben angeordnet ist.

Figur 5 zeigt ferner zwei zusätzliche Module 20, mit denen beschichtete oder unbeschichtete Oberflächen des Substrates, weiteren Behandlungen unterzogen werden können. Beispielsweise kann hier eine Oberfläche gezielt oxidiert oder gegebenenfalls geglättet werden.

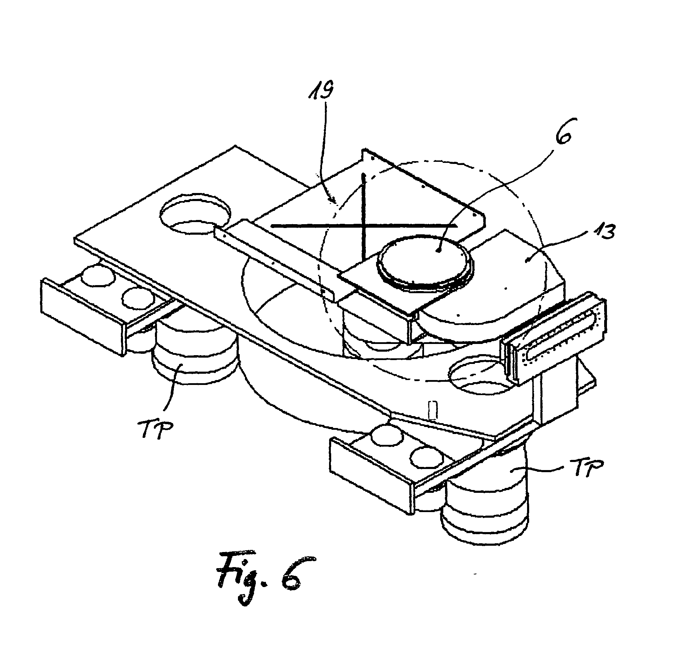

Figur 6 zeigt ähnlich Figur 3 ausschnittsweise einen Bestandteil der erfindungsgemäßen Beschichtungsvorrichtung, nämlich die Bewegungseinrichtung (ohne Gehäuse G) zum Bewegen des Substrates 6 unterhalb der Targettrommel. Auch hier in Figur 6 ist der mehrteilige Roboterarm zu erkennen, der eine exakte lineare Bewegung des Substrates 6 relativ zum Target ermöglicht.

## Patentansprüche

1. Vorrichtung zum Beschichten eines Substrates (6) mit magnetischen oder magnetisierbaren Werkstoffen mit:
(a) einer Zerstäubungskathode (1) mit
(a1) einem Kathodengrundkörper (2);
(a2) einem darauf angeordneten Target (3); und
(a3) einer hinter dem Target (3) angeordneten Magnetanordnung (4) zum
Erzeugen eines Magnetronfeldes;
(b) einer Einrichtung (5) zum Erzeugen eines externen Magnetfeldes mit im wesentlichen zueinander parallel verlaufenden Magnetfeldlinien (8) im wesentlichen in einer zum Target (3) parallelen Beschichtungsebene, in der das zu beschichtende Substrat (6) positionierbar ist: und
(c) einer Einrichtung zum Bewegen des Substrats (6) während der Kathodenzerstäubung relativ zum Target (3) in der Substratebene in Richtung der Magnetfeldlinien (8) des externen Magnetfeldes.

2. Vorrichtung nach Anspruch 1, wobei die Kathode (1) eine Langkathode ist.

3. Vorrichtung nach Anspruch 2, wobei sich die externe Magnetfelderzeugungseinrichtung (5) in Längsrichtung des Targets (3) erstreckt.

4. Vorrichtung nach einem der Ansprüche 1 bis 3, ferner mit einer Abschirmung (7) zum Abschirmen des nicht zu beschichtenden Bereiches der Vorrichtung zwischen Target (3) und Substrat (6).

5. Vorrichtung nach einem der Ansprüche 1 bis 4, wobei das Bewegen des Substrats eine lineare Relativbewegung darstellt.

6. Vorrichtung, nach einem der Ansprüche 1 bis 5 mit einer Prozesskammer, wobei der Kathodengrundkörper (2) mit dem darauf angeordneten Target (3) in der Prozesskammer und die Magnetanordnung (4) von dieser durch eine Wand getrennt in der Umgebungsatmosphäre angeordnet sind.

7. Vorrichtung (10) zum Beschichten eines Substrates (6) mit mehreren Schichten durch Kathodenzerstäubung mit magnetischen bzw. magnetisierbaren Werkstoffen mit:
einer zylindrischen Zerstäubungskathodenanordnung (11) mit mehreren Zerstäubungskathoden (11-1, 11-2, ..., 11-n) mit je einem Kathodengrundkörper (2, 14), einem darauf angeordneten Target (3-1, 3-2, ..., 3-n) und einer hinter dem Target angeordneten Magnetanordnung (4) zum Erzeugen eines Magnetronfeldes,
wobei die mehreren Zerstäubungskathoden mit der Targetnutzfläche radial nach außen weisend auf einem Kreis angeordnet sind, um dessen Achse (15) die Zerstäubungskathodenanordnung (11) relativ zu einer Beschichtungsebene drehbar ist, in der das Substrat (6) positionierbar ist und die im wesentlichen in einer Tangentialebene eines die Zerstäubungskathodenanordnung (11) umschreibenden Kreises angeordnet ist,
mit einer Einrichtung (5) zum Erzeugen eines externen Magnetfeldes mit im wesentlichen zueinander parallel und im wesentlichen in der Beschichtungsebene verlaufenden Magnetfeldlinien (8), und mit einer Einrichtung zum Bewegen des Substrats (6) während der Kathodenzerstäubung relativ zum Target (3-1,3-2,... 3-n) in der Substratebene in Richtung der Magnetfeldlinien (8) des externen Magnetfeldes.

8. Vorrichtung nach Anspruch 7, wobei die Zerstäubungskathoden Langkathoden sind.

9. Vorrichtung nach Anspruch 8, wobei sich die Magnetfelderzeugungseinrichtung (5) in Längsrichtung der Targets (3) erstreckt.

10. Vorrichtung nach Anspruch 77, 8 oder 9, wobei das Bewegen des Substrats eine lineare Relativbewegung darstellt.

11. Vorrichtung nach einem der Ansprüche 7 bis 10 mit einer Prozesskammer, wobei die Kathodengrundkörper (2) mit den darauf angeordneten Targets (3) in der Prozesskammer und die Magnetron-Magnetanordnungen (4) von dieser durch eine Wand (17) getrennt in der Umgebungsatmosphäre angeordnet sind.

12. Vorrichtung nach einem der Ansprüche 7 bis 11, wobei für die Zerstäubungskathodenanordnung nur eine oder zwei Magnetron-Magnetanordnungen (4) vorgesehen sind und die Kathodengrundkörper (2) mit den darauf angeordneten Targets (3) relativ zu den Magnetron-Magnetanordnungen (4) bewegbar sind.

13. Vorrichtung nach einem der Ansprüche 1 bis 12, wobei das externe Magnetfeld die leichte Magnetisierungsachse eines auf das Substrat (6) aufgebrachten Werkstoffes ausrichtet.

14. Vorrichtung nach einem der Ansprüche 1 bis 13, wobei die Stärke des externen Magnetfeldes einstellbar ist.

15. Verfahren zum Beschichten eines Substrats (6) durch Kathodenzerstäubung mit magnetischen bzw. magnetisierbaren Werkstoffen mit einer Vorrichtung nach einem der Ansprüche 1 bis 14, wobei während der Zerstäubung ein externes Magnetfeld mit im wesentlichen zueinander parallel und in der Beschichtungsebene des Substrats (6) verlaufenden Magnetfeldlinien (8) vorgesehen ist und das Substrat während der Beschichtung relativ zum Target in der Substratebene in Richtung der Magnetfeldlinien des externen Magnetfeldes bewegt wird.

16. Verfahren zum Beschichten eines Substrates mit mehreren Schichten mit magnetischen bzw. magnetisierbaren Werkstoffen mit der Vorrichtung nach einem der Ansprüche 7 bis 14, mit den Schritten:
(a) Aufbringen einer Schicht auf das Substrat (6) mittels einer ersten Zerstäubungskathode (11-1) ausgewählt aus den Zerstäubungskathoden (11-1, 11-2,...11-n), wobei während der Zerstäubung ein externes Magnetfeld mit im wesentlichen zueinander parallel und in der Beschichtungsebene des Substrats (6) verlaufenden Magnetfeldlinien (8) vorgesehen ist;
(b) translatorisches Bewegen des Substrates relativ zu der ersten Zerstäubungskathode (11-1) in der Ebene des Substrats (6) und in Richtung der Magnetfeldlinien (8) des externen Magnetfeldes während des Schrittes (a);
(c) Ersetzen der ersten Zerstäubungskathode (11-1) durch eine andere Zerstäubungskathode (11-2) ausgewählt aus den Zerstäubungskathoden (11-2,...11-n);
(d) Aufbringen einer Schicht auf das Substrat (6) mittels der anderen Zerstäubungskathode (11-2), wobei während der Zerstäubung ein externes Magnetfeld mit im wesentlichen zueinander parallel und in der Beschichtungsebne des Substrats (6) verlaufenden Magnetfeldlinien (8) vorgesehen ist; und
(e) translatorisches Bewegen des Substrates relativ zu der anderen Zerstäubungskathode (11-2) in der Ebene des Substrats (6) und in Richtung der Magnetfeldlinien (8) des externen Magnetfeldes während des Schrittes (d).

17. Verfahren nach ansprüch 15 oder 16, wobei die Geschwindigkeit der Bewegung des Substrats (6) in der Substratebene während des Schichtauftrags durch Kathodenzerstäubung in Abhängigkeit von der gewünschten Schichtdicke gesteuert wird.

18. Verfahren nach einem der Ansprüche 15 bis 17 zum Ausrichten der leichten Magnetisierungsachse eines auf das Substrat (6) aufgebrachten Werkstoffes durch das externe Magnetfeld.

## Claims

1. A device for coating a substrate (6) with magnetic or magnetizable materials, comprising:
(a) a sputtering cathode (1) comprising
(a1) a cathode base body (2);
(a2) a target (3) arranged thereon;
(a3) a magnet arrangement (4) provided behind the target (3) and intended for generating a magnetron field;
(b) a means (5) for generating an external magnetic field having magnetic field lines (8) which extend essentially parallel with each other essentially in a coating plane which extends parallel to the target (3) and in which the substrate (6) to be coated can be positioned, and
(c) a means for moving the substrate (6) during cathode sputtering relative to the target (3) in the substrate plane in the direction of the magnetic field lines (8) of the external magnetic field.

2. The device according to claim 1, wherein the cathode (1) is a long cathode.

3. The device according to claim 2, wherein the external magnetic field generation means (5) extends in the longitudinal direction of the target (3).

4. The device according to any one of claims 1 to 3, further comprising a shield (7) for shielding the area of the device which should not be coated between the target (3) and the substrate (6).

5. The device according to any one of claims 1 to 4, wherein the movement of the substrate is a linear relative movement.

6. The device according to any one of claims 1 to 5 with a process chamber, wherein the cathode base body (2) with the target (3) provided thereon is arranged in the process chamber and the magnet arrangement (4) is separated therefrom by means of a wall and located in the ambient atmosphere.

7. A device (10) for coating a substrate (6) with several layers by means of cathode sputtering with magnetic and/or magnetizable materials, comprising:
a cylindrical sputtering cathode arrangement (11) comprising a plurality of sputtering cathodes (11-1, 11-2, ..., 11-n) each having a cathode base body (2, 14), a target (3-1, 3-2, ..., 3-n) arranged thereon and a magnet arrangement (4) provided behind the target and intended for generating a magnetron field;
wherein the plurality of sputtering cathodes are located on a circle with their target effective areas pointing radially outward, and the sputtering cathode arrangement (11) can be rotated around the axis (15) of said circle relative to a coating plane in which the substrate (6) can be positioned and which is essentially arranged in a tangential plane of a circle enclosing the sputtering cathode arrangement (11);
a means (5) for generating an external magnetic field having magnetic field lines (8) which extend essentially parallel with each other and essentially in the coating plane, and
a means for moving the substrate (6) during cathode sputtering relative to the target (3-1,3-2,..., 3-n) in the substrate plane in the direction of the magnetic field lines (8) of the external magnetic field.

8. The device according to claim 7, wherein the sputtering cathodes are long cathodes.

9. The device according to claim 8, wherein the magnetic field generation means (5) extends in the longitudinal direction of the targets (3).

10. The device according to claim 7, 8 or 9, wherein the movement of the substrate is a linear relative movement.

11. The device according to any one of claims 7 to 10 comprising a process chamber, wherein the cathode base bodies (2) with the targets (3) arranged thereon are provided in the process chamber and the magnetron magnet arrangements (4) are separated therefrom by means of a wall (17) and located in the ambient atmosphere.

12. The device according to any one of claims 7 to 11, wherein only one or two magnetron magnet arrangement(s) (4) is/are provided for the sputtering cathode arrangement and the cathode base bodies (2) with the targets (3) arranged thereon are movable relative to the magnetron magnet arrangements (4).

13. The device according to any one of claims 1 to 12, wherein the external magnetic field aligns the easy magnetization axis of a material being applied to the substrate (6).

14. The device according to any one of claims 1 to 13, wherein the strength of the external magnetic field is adjustable.

15. A method for coating a substrate (6) by means of cathode sputtering with magnetic and/or magnetizable materials and comprising a device according to any one of claims 1 to 14, wherein an external magnetic field having magnetic field lines (8) extending essentially parallel with each other and in the plane of the substrate (6) is provided during sputtering and the substrate is moved during coating relative to the target in the substrate plane in the direction of the magnetic field lines of the external magnetic field.

16. A method for coating a substrate with several layers with magnetic and/or magnetizable materials by means of the device according to any one of claims 7 to 14, comprising the steps:
(a) applying a layer on the substrate (6) by means of a first sputtering cathode (11-1) which is selected from the sputtering cathodes (11-1, 11-2, ..., 11-n), wherein during sputtering an external magnetic field having magnetic field lines (8) extending essentially parallel with each other and in the plane of the substrate (6) is provided;
(b) a translatory movement of the substrate relative to the first sputtering cathode (11-1) in the plane of the substrate (6) and in the direction of the magnetic field lines (8) of the external magnetic field during step (a);
(c) replacing the first sputtering cathode (11-1) with a different sputtering cathode (11-2) selected from the sputtering cathodes (11-2, ..., 11-n);
(d) applying a layer onto the substrate (6) by means of the other sputtering cathode (11-2), wherein during sputtering an external magnetic field having magnetic field lines (8) extending essentially parallel with each other and in the coating plane of the substrate (6) is provided; and
(e) a translatory movement of the substrate relative to the other sputtering cathode (11-2) in the plane of the substrate (6) and in the direction of the magnetic field lines (8) of the external magnetic field during step (d).

17. The method according to claim 15 or 16, wherein the movement speed of the substrate (6) in the substrate plane is controlled during the application of the layer by means of cathode sputtering depending on the desired layer thickness.

18. The method according to any one of claims 15 to 17 for aligning the easy magnetization axis of a material being applied to the substrate (6) by the external magnetic field.

## Revendications

1. Installation de revêtement d'un substrat (6) avec des matériaux magnétiques ou magnétisables, comportait
(a) une cathode de pulvérisation (1) avec
(a1) un corps de base de cathode (2);
(a2) une cible (3) disposée sur celui-ci ; et
(a3) un système d'aimant (4) disposé derrière la cible (3) pour générer un champ de magnétron ;
(b) un dispositif (5) destiné à générer un champ magnétique externe avec des lignes de champ magnétique (8) s'étendant sensiblement parallèlement entre elles, essentiellement sur un plan de revêtement parallèle à la cible (3), sur lequel le substrat (6) à revêtir peut être mis en place, et
(c) un dispositif de déplacement du substrat (6) par rapport à la cible (3) pendant la pulvérisation cathodique, sur le plan de substrat en direction des lignes de champ magnétique (8) du champ magnétique externe.

2. Installation selon la revendication 1, où la cathode (1) est une cathode longue.

3. Installation selon la revendication 2, où le dispositif de génération du champ magnétique externe (5) s'étend en direction longitudinale de la cible (3).

4. Installation selon l'une des revendications 1 à 3, comprenant en outre un écran (7) pour le blindage de la zone de l'installation à ne pas revêtir entre cible (3) et substrat (6).

5. Installation selon l'une des revendications 1 à 4, où le déplacement du substrat représente un déplacement linéaire relatif.

6. Installation selon l'une des revendications 1 à 5, comportant une chambre de processus, le corps de base de cathode (2) et la cible (3) disposée sur celui-ci étant agencés dans ladite chambre de processus et le système d'aimant (4) étant séparé de cette dernière par une cloison et disposé dans l'atmosphère ambiante.

7. Installation (10) de revêtement d'un substrat (6) avec plusieurs couches de matériaux magnétiques ou magnétisables par pulvérisation cathodique, comportant :
un dispositif à cathodes de pulvérisation cylindrique (11) avec plusieurs cathodes de pulvérisation (11-1, 11-2, ..., 11-n) ayant chacune un corps de base de cathode (2, 14), une cible (3-1, 3-2, ..., 3-n) disposée sur celui-ci et un système d'aimant (4) disposé derrière la cible pour générer un champ de magnétron,
les plusieurs cathodes de pulvérisation étant disposées sur un cercle avec la surface utile de cible radialement dirigée à l'extérieur, autour de l'axe (15) duquel le dispositif à cathodes de pulvérisation (11) est rotatif par rapport à un plan de revêtement sur lequel le substrat (6) peut être mis en place et qui est situé sensiblement sur un plan tangentiel à un cercle entourant le dispositif à cathodes de pulvérisation (11),
un dispositif (5) de génération d'un champ magnétique externe avec des lignes de champ magnétique (8) s'étendant sensiblement parallèlement entre elles et essentiellement sur le plan de revêtement, et
un dispositif de déplacement du substrat (6) par rapport à la cible (3-1, 3-2,..., 3-n) pendant la pulvérisation cathodique, sur le plan de substrat en direction des lignes de champ magnétique (8) du champ magnétique externe.

8. Installation selon la revendication 7, où les cathodes de pulvérisation sont des cathodes longues.

9. Installation selon la revendication 8, où le dispositif de génération du champ magnétique externe (5) s'étend en direction longitudinale des cibles (3).

10. Installation selon la revendication 7, 8 ou 9, où le déplacement du substrat représente un déplacement linéaire relatif.

11. Installation selon l'une des revendications 7 à 10, comportant une chambre de processus, les corps de base de cathode (2) et les cibles (3) disposées sur ceux-ci étant agencés dans ladite chambre de processus et les systèmes d'aimant - de magnétron (4) étant séparés de cette dernière par une cloison (17) et disposés dans l'atmosphère ambiante.

12. Installation selon l'une des revendications 7 à 11, où pour le dispositif à cathodes de pulvérisation ne sont prévus qu'un ou deux systèmes d'aimant - de magnétron (4) et où les corps de base de cathode (2) et les cibles (3) disposées sur ceux-ci sont déplaçables par rapport aux systèmes d'aimant - de magnétron (4).

13. Installation selon l'une des revendications 1 à 12, où le champ magnétique externe oriente l'axe de magnétisation léger d'un matériau appliqué sur le substrat (6).

14. Installation selon l'une des revendications 1 à 13, où l'épaisseur du champ magnétique externe est réglable.

15. Procédé de revêtement d'un substrat (6) par pulvérisation cathodique de matériaux magnétiques ou magnétisables, comportant une installation selon l'une des revendications 1 à 14, où, pendant la pulvérisation, il est prévu un champ magnétique externe avec des lignes de champ magnétique (8) s'étendant sensiblement parallèlement entre elles et sur le plan de revêtement du substrat (6), et où, pendant la pulvérisation, le substrat est déplacé par rapport à la cible, sur le plan de substrat en direction des lignes de champ magnétique du champ magnétique externe.

16. Procédé de revêtement d'un substrat avec plusieurs couches de matériaux magnétiques ou magnétisables au moyen de l'installation selon l'une des revendications 7 à 14, comportant les étapes suivantes:
(a) application d'une couche sur le substrat (6) au moyen d'une première cathode de pulvérisation (11-1) sélectionnée parmi les cathodes de pulvérisation (11-1, 11-2,..., 11-n), un champ magnétique externe avec des lignes de champ magnétique (8) s'étendant sensiblement parallèlement entre elles et sur le plan de revêtement du substrat (6) étant prévu pendant la pulvérisation ;
(b) déplacement translatoire du substrat par rapport à la première cathode de pulvérisation (11-1) sur le plan du substrat (6) et en direction des lignes de champ magnétique (8) du champ magnétique externe lors de l'étape (a);
(c) remplacement de la première cathode de pulvérisation (11-1) par une autre cathode de pulvérisation (11-2) sélectionnée parmi les cathodes de pulvérisation (11-2,..., 11-n) ;
(d) application d'une couche sur le substrat (6) au moyen de l'autre cathode de pulvérisation (11-2), un champ magnétique externe avec des lignes de champ magnétique (8) s'étendant sensiblement parallèlement entre elles et sur le plan de revêtement du substrat (6) étant prévu pendant la pulvérisation ; et
(e) déplacement translatoire du substrat par rapport à l'autre cathode de pulvérisation (11-2) sur le plan du substrat (6) et en direction des lignes de champ magnétique (8) du champ magnétique externe lors de l'étape (d).

17. Procédé selon la revendication 15 ou la revendication 16, où la vitesse de déplacement du substrat (6) sur le plan de substrat pendant l'application de couche par pulvérisation cathodique est commandée en fonction de l'épaisseur de couche souhaitée.

18. Procédé selon l'une des revendications 15 à 17, pour l'orientation de l'axe de magnétisation léger d'un matériau appliqué sur le substrat (6) par le champ magnétique externe.
